# EUROPEAN PATENT APPLICATION

(11) **EP 4 668 016 A1**
(43) Date of publication of application: **24.12.2025**
(21) Application number: 24305948.2
(22) Date of filing: 17.06.2024
(51) Int. Cl.: G03F 7/00

(54) **METHOD FOR DETERMINING A DIMENSION OF A STRUCTURE FORMED ON A SUBSTRATE**

(71) Applicant: Commissariat à l'Energie Atomique et aux Energies Alternatives, 75015 Paris (FR)
(72) Inventor: LAULAGNET, Fabien, 38054 GRENOBLE CEDEX 09 (FR); DALLERY, Jacques-Alexandre, 38960 SAINT-AUPRE (FR)
(74) Representative: Cabinet Camus Lebkiri

(57) **Abstract**

The invention relates to a method (100) for determining a dimension (DM1) between two opposite edges (11,12) of a structure (1) formed on a substrate (3), by:
- Forming on the substrate (3), by a lithographic apparatus, a first target (21) and a second target (22) facing the first target (21) and separated from the first target (21) by a predefined reference distance (DREF),
- Acquiring using a microscopy tool, a first image (IMG1) of a first local aera including the first target (21) and the first edge (11), and a second image (IMG2) of a second local aera including the second target (22) and the second edge (12),
- Measuring in the first image (IMG1) a first distance (OFFSET1) between the first target (21) and the first edge (11), and in the second image (IMG2), a second distance (OFFSET2) between the second target (22) and the second edge (12),
- Computing the measured first and second distances (OFFSET1, OFFSET2) and the predefined reference distance (DREF).

## Description

### TECHNICAL FIELD

The technical field of the invention is the metrology, and more particularly the dimensional metrology for semiconductors.

The present invention has for object a metrology method, and more particularly a metrology method for accurately measuring large, millimeter-sized, dimensions in patterns produced on a substrate, such as patterns of a semiconductor device.

### STATE OF THE ART

Over the past ten years, device and integrated circuit (IC) technology has rapidly evolved toward the use of complex 3D device structures using new materials, patterning techniques, and processes which provide higher device performance with smaller feature sizes.

Metrology needs are increasingly affected by these evolutions. For instance, the development of stacking technologies such as 3D, wafer-to-wafer (W2W) and die-to-wafer (D2W) place significantly more difficult requirements on dimensional metrology. Such a difficult requirement is the need to characterize lateral dimensions of millimeter-scale structures (e.g., structures having an aera of 0,5 × 0,5 mm² or more) with an accuracy of at least 30 nm.

Microscopy is used in most of the core technology processes where 2D distributions, which are digital images of the shape and appearance of IC features, reveal important information. Metrology systems enabling microscopy typically employ light, electron beam, X-ray, or scanned probe methods. They have imaging capabilities generally combined with microscopy applications that include lateral dimension measurement (such as linewidth) or shape recognition.

However, single microscopy cannot achieve the combination of range and accuracy.

Light microscopy resolution fundamentally is limited by the wavelength of visible light, allowing it to resolve structural details no smaller than several hundred nanometers, which is far above the desired accuracy.

The scanning electron microscope (or SEM) and its high-resolution version the critical-dimension scanning electron microscope (or CD-SEM) have become the most widely used of all advanced imaging tools because of their capability to image and resolve features with sizes below 5 nm.

However, this spatial resolution is only achieved within small imaging aeras, typically imaging aeras of a few microns square, for instance aeras of 5 µm × 5 µm or 3 µm × 3 µm, or less. SEM microscopes (including CD-SEM microscope), as standard light microscopes, have indeed not resolved the trade-off between field-of view (size of the imaging aera) and spatial resolution (the size of the smallest feature that can be resolved).

Therefore, to achieve, by microscopy, dimensional measurements on large, millimetric structures with the desired nanometer accuracy, it is generally required to combine individual small high-resolution images according to a method currently called image stitching method. This method is yet time-consuming, since it consists in moving the stages of the microscope to adjacent fields-of view and forming a grid of images from the data acquired at each field-of view.

There is therefore a need for a more straightforward method to achieve a dimensional measurement with the desired combination of large range and extreme accuracy.

### SUMMARY OF THE INVENTION

The present invention aims to satisfy this need by providing an indirect dimensional measurement method wherein the dimension is obtained with the desired accuracy from only two images acquired by microscopy and two measurements taken on each of these images, thanks to a two-target based reference device realized by lithography in the vicinity of the structure.

To this end, one aspect of the invention pertains to a method for determining a dimension between two opposite edges of a structure formed on a substrate, comprising the steps of:
- Forming on the substrate, by a lithographic apparatus, a reference device comprising a first and a second target facing each other and separated by a predefined distance,
   - Wherein the first target is positioned close toa first edge of the two opposite edges,
   - wherein the second target is positioned close to a second edge of the two opposite edges, said first and second targets being separated by said predefined reference distance,
- Performing, using a microscopy tool, dimensional measurements between the structure and the formed reference device, by:
   - Acquiring a first image of a first local aera including the first target and the first edge, and a second image of a second local aera including the second target and the second edge,
   - Measuring in the first image a first distance between the first target and the first edge, and, in the second image, a second distance between the second target and the second edge,
- Computing the measured first and second distances and the predefined reference distance to determine the dimension between the opposite edges.

Thanks to the invention, the predefined reference distance is used together with the results of the measurements of the first and second distances to determine the dimension of the structure. This dimension of the structure is thus determined with an accuracy that depends on the accuracy with which the predefined reference distance is known, and on the resolution (and thus the size) of the first and second images on which the first and second distances are measured. These two components (accuracy of the predefined reference distance and resolution of the image) basically depend on the ability of the lithography device to accurately position the first and second targets relative to each other and relative to the edges of the structure (the closer the targets are to the edges, the smaller the images).

Thusly, the accuracy with which the dimension is determined is totally uncorrelated to the value of the dimension itself. The dimension and accuracy can therefore be of very different orders of magnitude: for example, the dimension of the structure can be in the millimeter range, typically larger than 500 µm or larger than 1 mm, and the accuracy can be in the micrometer or the sub-micrometer range, typically below 10 µm, or below 1 µm, or even below 30 nm. These levels of accuracy are feasible because the lithography apparatus currently employed in the microelectronic industry already achieve placement accuracy better than 10 µm, or better than 1 µm, or even better than 30 nm.

Moreover, since only two images are acquired and one measurement on each of these images are only needed, the method is simpler than the current methods based on image stitching.

Advantageously, the first target is positioned with respect to the first edge of the structure so that the first distance is less than or equal to 50 µm, more preferably less than or equal to 10 µm, and for instance less than or equal to 5 µm, and the second the second target is positioned with respect to the second edge of the structure so that the second distance is less than or equal to 50 µm, more preferably less than or equal to 10 µm, and for instance less than or equal to 5 µm.

By positioning the first target and second target at such a close distance from the first and second edges of the structure respectively, the first and second images can be acquired within a field-of-view allowing a resolution in the sub-micrometer range or in the nanometer range.

Advantageously, the first target overlaps the first edge of the structure or is positioned, with respect to the first edge of the structure, outside the structure or on the structure, and the first target has at least an end facing a portion of the first edge of the structure, the distance between the end of the first target and the portion of the first edge being equal to the first distance.

Advantageously, the second target overlaps the second edge of the structure or is positioned, with respect to the second edge of the structure, outside the structure or on the structure, and the second target has at least an end) facing a portion of the second edge of the structure, the distance between the end of the second target and the portion of the second edge being equal to the second distance.

This allows to position the first and second targets with respect to the structure with a certain degree of freedom, making the method flexible to implement. The variety of positions allowed for the first and second targets also allows the use a large variety of target designs and shapes.

Advantageously, the lithographic apparatus can form patterns with a lateral resolution of at least 10 nm and placement accuracy of at least 1 nm.

Advantageously, the lithographic apparatus is an electron beam lithographic apparatus.

Thanks to these lithographic apparatus capabilities, the reference distance is known with an accuracy better than 30 nm, and the first and second targets are positioned close enough to the respective edges of the structure (namely, the first edge and the second edge) so that the first and second images have a size of a few microns square (3 µm × 3 µm or less). The advantage is that such small images have a resolution better than 30 nm. The dimension can thus be determined with an accuracy of at least 30 nm.

Advantageously, the microscopy tool allows non-destructive critical dimension measurement.

Preferably, the microscopy tool is a critical-dimension scanning electron microscope, also called CD-SEM.

The resolution of the first and second images are then increased and the first and second distances are measured with increased accuracy and reproducibility.

Preferably, the computing step is followed by an additional step of selective removing of the first and second targets from the substrate.

The method is then made non-invasive and non-destructive.

In one embodiment, the first target and the second target are each made of one mark.

In a preferred embodiment, the first and the second target are each made of a plurality of marks, wherein each mark of the plurality of marks is connected to at least another mark of the plurality of marks.

in the preferred embodiment, the first target and the second target are preferably each made of five marks having rectangular shapes and arranged such to form a bridge-like structure, the bridge-like structure including two pillars, and a plate extending over the two pillars, perpendicularly to the two pillars and connected to the two pillars.

Preferably, the first target having the bridge-like structure is positioned so that the plate of the first target overlaps the first edge of the structure, one of the pillars of the first target being positioned outside the structure, and the other pillar being positioned on the structure, and the second target having the bridge-like structure is positioned so that the plate of the second target overlaps the second edge of the structure, one of the pillars of the second target being positioned outside the structure and the other pillar being positioned on the structure.

By using the bridge-like structures for the first and second targets, and by positioning these bridge-like structures across the first and second edges respectively, several pairs of first and second distances can be measured along the first and second edges of the structure. The dimension of the structure is then determined for each of these pairs, which improves the robustness of the method to variabilities (or irregularities) of the structure's edges.

### BRIEF DESCRIPTION OF THE FIGURES

Other characteristics and advantages of the invention will become clear from the description that is given thereof below, by way of indication and in no way limiting, with reference to the appended figures, among which:
Fig. 1 is a flowchart illustrating the steps of a preferred embodiment of the invention,
Fig. 2 depicts a structure on which the invention is performed,
Fig. 3 illustrates the main steps of the invention, by representing a two-target reference device formed on the structure of figure 2, and by showing a first CD-SEM image of the first target of the reference device, and a second CD-SEM image of the second target of the reference device, the first and second targets having a simple design,
Fig. 4 shows a CD-SEM image of a first target having an alternative simple design,
Fig. 5 represents a first target having a complex design and being positioned in relation to the first edge,
Fig. 6 is a flowchart illustrating the sub-steps of the first step of the flowchart of figure 1,
Fig. 7 is a flowchart illustrating the sub-steps of the second step of the flowchart of figure 1.

### DETAILED DESCRIPTION

For greater clarity, identical or similar elements are marked by identical reference signs in all of the figures.

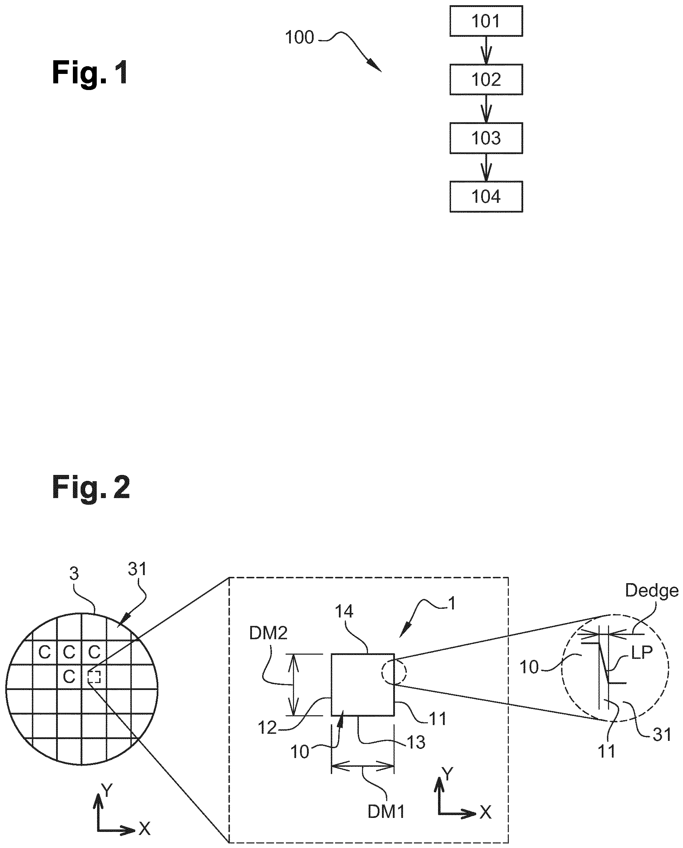

The invention relates to a dimensional metrology method 100, illustrated on figure 1, for determining lateral dimensions of millimeter-sized structures formed on a substrate with an accuracy that is better than 1 µm, and preferably better than 30 nm.

Figure 2 depicts an example of structure 1 formed on a substrate 3 on which the method 100 is performed.

The substrate 3 is for example a semiconductor wafer (abbreviated as just "wafer"), such as a silicon wafer. The substrate 3 may in some cases be of a different nature, for instance glass. In general, a single substrate 3 will contain a grid of adjacent semiconductor devices C, referred to as chips or dies formed layer by layer, by many types of processes involved in semiconductor manufacturing. Lithography is one the process involved. The term "semiconductor device" includes but is not limited to integrated circuits (ICs), micro- and nano- systems including nano-photonics, nano-fluidics or nano-mechanics devices, sensors, or actuators.

Typically, the structure 1 is such a semiconductor device C formed on the substrate 3, or a feature within a semiconductor device C. The structure 1 lies in a plane 31 of the substrate 3. The plane 31 of the substrate 3 is at least defined by two orthogonal axes X and Y, respectively defining coordinates x and y. Each pair of coordinates (x,y) corresponds to a position in the reference frame of the substrate 3.

In the description, the structure 1 is presented with a shape (or a layout) that is geometrically simple, for instance a square or a rectangle. However, the structure 1 may also present various and more complex designs.

In the remainder of the description, the structure 1 is considered in the plane 31 of the substrate 3.

As illustrated in Figure 2, the structure 1 has lateral dimensions DM1, DM2, also simply called dimensions. Each dimension DM1, DM2 of the structure 1 is delineated by (or between) two opposite edges of the structure 11-12 (DM1), and 13-14 (DM2). The dimensions DM1, DM2 that can be large, namely in the range of millimeter scale. As an example, the structure presents dimensions DM1, DM2 respectively in the X and Y directions, that can each be greater than 0,5 mm, and preferably greater than 1 mm. For instance, the dimensions DM1 and DM2 of the structure 1 are each equal to 1 mm, or 8 mm, or 16 mm. It should be noted that the method 100 is also compatible with a structure 1 having smaller dimensions DM1, DM2, for example dimensions less than 0,5 mm.

Referring to Figure 2, the opposite edges 11,12 or 13,14 of the structure 1 can have a line profile LP (measured by microscopy) of about 10-50 nm in width (cf. "Dedge" in figure 2), with a slope that only spans over a few nanometers.

The method 100 is now explained in relation to figure 1, figure 3, figure 4, figure 5, figure 6, and figure 7.

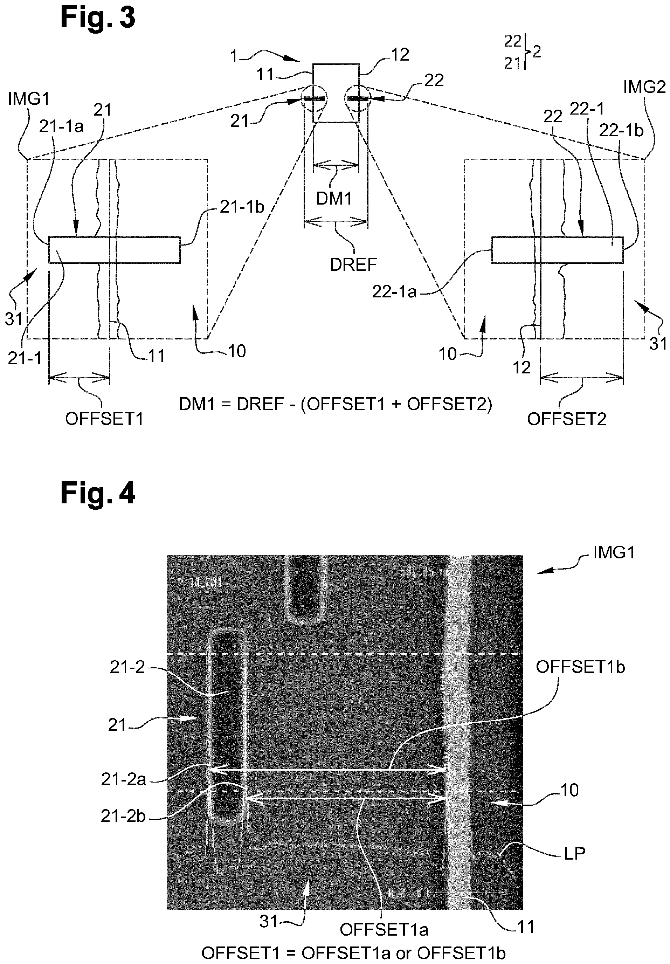

The method 100 is aimed at measuring indirectly the dimension DM1 or the dimension DM2 of the structure 1. In the remainder of the description, the dimension to be determined is the dimension DM1 between the two opposite edges 11,12 of the structure 1 (cf. Figure 3).

In common to every embodiment of the method, the method 100 comprises a first step 101, a second step 102, and a third step 103 (cf. Figure 1).

In reference to Figure 3, the first step 101 consists in forming, using a lithographic apparatus, a reference device 2 on the substrate 3, in the vicinity of the structure 1. Precisely, the reference device 2 is made of two targets 21,22 that face each other and frame the two opposite edges 11,12 of the structure 1.

More precisely, as illustrated in Figure 3, the first and second targets 21, 22 are separated by a predefined reference distance DREF, and the first target 21 is positioned close to the first edge 11 whereas the second target 22 is positioned close to the second edge 12.

As will become clearer in the description of step 102, the expression "close to the first edge" is taken to mean at a first distance from the structure's first edge 11 that is short enough so that the first target 21 and the portion of the first edge 11 that faces this first target are imaged together in a single microscopy image IMG1 (called "first image IMG1" in the remainder of the description). The first distance is noted OFFSET1 in Figure 3. It is taken between an edge 21-1 of the first target 21 and the portion of the first edge 11 that faces this edge 21-1 of the first target 21.

Similarly, the expression "close to the second edge", is taken to mean at a second distance from the structure's second edge 12 that is short enough so that the second target 22 and the portion of the second edge 12 that faces this second target 22 are imaged together in a single microscopy image IMG2 (called "second image IMG2" in the remainder of the description). The second distance is noted OFFSET2 in Figure 3. It is taken between an edge 22-1 of the second target 22 and the portion of the second edge 11 that faces this edge 22-1 of the second target 22.

Advantageously, the first distance OFFSET1 is less than 50 µm, more preferably less than 10 µm, and more preferably less than 5 µm.

Similarly, the second distance OFFSET2 is less than 50 µm, more preferably less than 10 µm, and more preferably less than 5 µm.

The shorter the first and second distances OFFSET1, OFFSET2, the smaller the size (and thus the better the resolution) of the first and second images IMG1 and IMG2. This feature is important because, as it will be described later, the first and second distances will be further measured in step 102, using the first and second images IMG1 and IMG2, respectively. Therefore, the better the resolution of the first and second images IMG1, IMG2, the better the accuracy of the measurement of the first and second distances OFFSET1, OFFSET2.

The first target 11 can be positioned across the first edge 11, as in Figure 3. Alternatively, the first target 21 can be positioned outside 31 the structure, as illustrated in Figure 4. Alternatively, the first target 11 can be positioned on 10 the structure 1 (not represented by the figures). It should be noted that the first target 21 has then at least an end that faces a portion of the first edge 11 of the structure 1, and the distance between this end and the portion of the first edge is the first distance OFFSET1.

In addition, whatever the position of the first target 21 (across the first edge 11 or outside or on the structure and close to the first edge 11), the second target 22 can be positioned across the second edge 12, as in Figure 3, or solely outside 31 the structure 1, or solely on the structure 1 (not represented by the figures). The second target 22 has then at least an end that faces a portion of the second edge 12 of the structure 1, and the distance between this end and the portion of the second edge is the second distance OFFSET2.

. It should also be noted that, whatever the relative positions of the targets 21,22 with respect to the structure's edges, they always face each other (namely, they are disposed along the same direction). In this way, the first and second distances will be measured along the same axis (same direction) and will constitute a pair of first and second distances {OFFSET1, OFFSET2}.

This variety of possible positions of the first and second targets 21,22 with respect to the first and second edges 11,12 of the structure 1 makes the method 100 flexible and allows many designs (shapes, orientation, position) for the first and second targets 21,22.

Different examples of target designs are described below.

In the example represented in Figure 3, each of the first and second targets 21,22 is made of a simple mark. This mark is referenced 21-1 when forming the first target and 22-1 when forming the second target 22.

Each mark 21-1, 21-2 is here rectangular and oriented perpendicularly to the first and second edges 11, 12 of the structure 1. Precisely, the mark 21-1 is positioned so that its length side is perpendicular to the first edge 11 and so that it overlaps the first edge 11. In other words, the first target 21 overlaps the first edge 11.

As illustrated in Figure 3, the first distance OFFSET1 is here defined between one of the end 21-1a or 21-1b of the mark 21-1 and the portion of the first edge 11 that faces these ends 21-1a, 21-1b. The ends 21-1a, 21-1b considered are in fact parallel to the first edge 11.

As illustrated in Figure 3, the mark 21-2 forming the second target 22 faces the mark 21-1 forming the first target (its length side is perpendicular to the second edge 12) and overlaps the second edge 12. The second distance OFFSET2 is here defined between one of the end 22-1a or 22-1b of the mark 22-1 and the portion of the second edge 12 that faces these ends 22-1a, 22-1b. The ends 22-1a, 22-1b that are considered are in fact parallel to the second edge 12.

In another example, illustrated in Figure 4, the first target 21 is also made of a simple, rectangular mark, noted 21-2 in the figure, but the mark 21-2 is positioned differently to the Figure 3.

As illustrated in figure 4, the mark 21-2 forming the first target 21 is here positioned entirely outside the structure 1. Besides, the mark 21-2 has its length side parallel to the first edge 11. In this configuration, the first distance OFFSET1 is the distance OFFSET1a between the first edge 11 and the closest end 21-2b of the mark 21-2, or the distance OFFSET1b between the first edge 11 and the farthest end 21-2a of the mark 21-2. Alternatively, the mark 21-2 can be positioned on the other side of the first edge 11, that is entirely on the structure 1 (not represented by the figures). Similar shape, orientation and position is used for the second target 22 (not represented by the figures).

In the example of figure 4, the length of the mark 21-2 is 0.5 µm, the distance OFFSET1a between the first edge 11 and the closest end 21-2b of the mark 21-2 is 0.6 µm.

In a preferred embodiment of the method 100, the first and second targets 21,22 have a design that is more complex than the ones depicted previously.

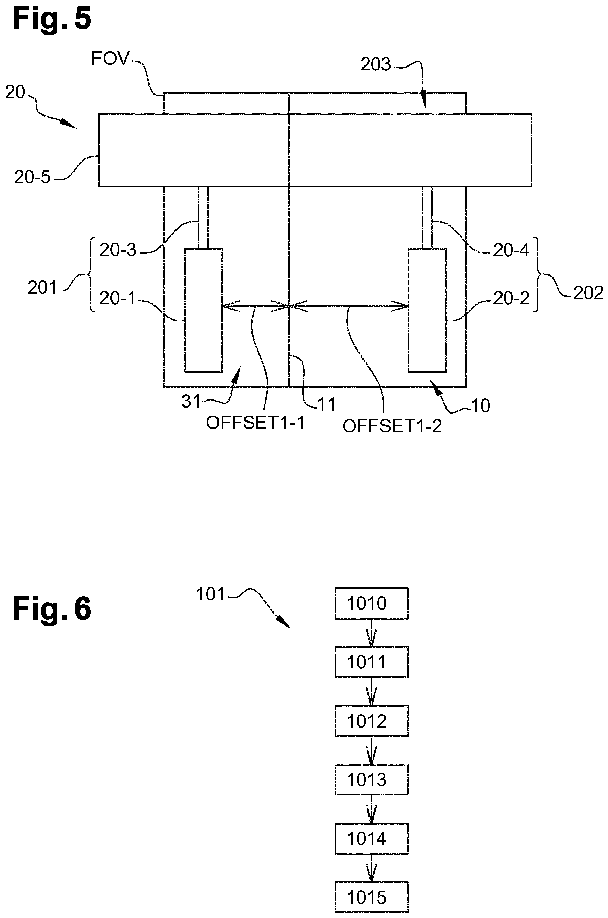

As illustrated in figure 5, the design is said complex when the first or second target 21 or 22 is made of a plurality of marks 20-1, 20-2, 20-3, 20-4, 20-5, each mark of the plurality of marks being connected to another mark of the plurality of marks.

The use of several marks enables to measure several pairs of first and second distances {OFFSET1, OFFSET2}, since a pair of first and second distances can be measured between each mark of the first and second targets.

Preferably, as illustrated in figure 5, the complex design can comprise five rectangular-shaped marks 20-1, 20-2, 20-3, 20-4 and 20-5 arranged to form a bridge-like structure 20.

Precisely, this bridge-like structure 20 has two parallel pillars 201, 202 and a plate 303 that is connected on top of to the two pillars 201, 202.

The first pillar 201 is formed by the first and third mark 20-1 and 20-3 that are arranged lengthwise on top of and connected to each other.

The second pillar 202 is formed by the second and fourth mark 20-2 and 20-4 that are arranged lengthwise on top of and connected to each other.

Finally, the fifth mark 20-5 is positioned lengthwise on top of and connected to the third and fourth marks 20-3 and 20-4.

The first mark 20-1 and second mark 20-2 can have the same size, which is for example 300 nm × 1200 nm.

The third and fourth marks can also have the same size, which is for example 60 nm × 600 nm.

The fifth mark 20-5 is larger in size than the other marks 20-1, 20-2, 20-3, 20-4. For example, the fifth mark 20-5 has a size of 4000 nm × 800 nm.

The first mark 20-1 and the second mark 20-2 are separated by a distance that is for example 2000 nm. This distance between the first and second marks 20-1 and 20-2 of the bridge-like structure 20 corresponds to the sum of the distances noted OFFSET1-1 and OFFSET1-2 in Figure 5.

The bridge-like structure 20 of the first target 21 is positioned so that the first pillar 201 is located outside the structure 1, the second pillar 202 is located on the structure 1, and the plate 203 overlaps the first edge 11. In other words, according to this arrangement, the first target 21 overlaps the first edge 11. The bridge-like structure of the second target 22 (the two targets have the same design) faces the bridge-like structure of the first target 21 and can be positioned with respect to the second edge 12 as the bridge-like structure of the first target is positioned with respect to the first edge.

The bridge-like structure 20 may be disposed symmetrically or non-symmetrically with respect to the first edge 11.

The non-symmetrical disposition is illustrated in Figure 5. Preferably, in this configuration, the distance OFFSET1-1 between the first edge 11 and the first mark 20-1 (taken edge-to-edge) is 800 nm, and the distance OFFSET1-2 between the first edge 11 and second mark 20-2 (also taken edge-to-edge) is 1200 nm.

The first distance OFFSET1 is, in this configuration, either the distance OFFSET1-1 or the distance OFFSET1-2.

Preferably, the lithographic apparatus can form patterns with a lateral resolution of 10 nm and placement accuracy of 1 nm. Here, lateral resolution (or spatial resolution or simply resolution) refers to the minimum size of a feature that can be patterned. Placement accuracy refers to the deviation of pattern position relatively to the reference grid of the design.

Such capabilities, and especially the placement accuracy capability, enable the first target 21 and the second target 22 to be placed close enough to the first edge 11 and close enough to the second edge 11,12, respectively, so that the first and second images IMG1, IMG2 are less than 100 µm × 100 µm in size, preferably less than 50 µm × 50 µm in size, and preferably less than 3 µm × 3 µm in size.

For instance, as in Figure 4, the first image IMG1 is 1 µm × 1 µm in size.

Besides, the nanometer placement accuracy of the lithography apparatus enables to place the first target 21 very precisely with respect to the second target 22 (or vice-versa). The predefined reference distance DREF is then known theoretically (that is by design) with an accuracy that is at the same nanometer order.

Preferably, the lithographic apparatus is an electron beam lithographic apparatus (or EBL). For instance, the electron beam lithography is performed by the electron beam lithography tool commercialized by the company VISTEC Electron Beam GmbH. Such an EBL apparatus has indeed a lateral resolution of 10 nm and placement accuracy of 1 nm.

The lithographic apparatus can also be an advanced optical lithographic apparatus.

When the EBL apparatus is used as the lithography apparatus, the method 100 comprises, in step 101, a sub-step 1010 (illustrated in Figure 6) that consists in providing the EBL apparatus with data (or layout) representing the reference device 2.

The data representing the reference device 2 comprises information about the design (including shape and dimensions) of the two targets 21, 22, as well as information about their position on the substrate 3.

The sub-step 1011 consists in aligning the EBL apparatus with respect to various elements already present on the substrate 3 and with respect to the positioning of the equipment used to fabricate the structures 1. The elements already present on the substrate 3 can be the structures 1. It should be noted that the EBL has in fact the advantage of not requiring dedicated alignment features. At the end of sub-step 1011, the stages of the lithography system are calibrated so that the reference frame of the lithography system meets the substrate reference frame.

The sub-step 1012 consists in depositing an electron-beam sensitive film, called a resist, onto the substrate 3. Importantly the resist is deposited on the whole surface 31 of the substrate 3.

The sub-step 1013 is an exposure step. The exposure step consists in scanning the focused beam of electrons of the EBL system to draw the first target 21 and the second target 22 of the reference device 2 on the surface of the substrate 3 covered with the resist.

The step 1014 consists in the annealing of the exposed resist.

The step 1015 is a development step. It consists in removing the resist, thereby allowing the first target 21 and the second target 22 to appear. The development step can be achieved by reactive ion etching (or RIE) or plasma etching.

At the end of step 1015, the first and second targets 21, 22 are formed on either side of the structure 1 and the distance between them (the so-called predefined reference distance DREF) is known by design, with an accuracy that is, thanks to the placement accuracy provided by the EBL apparatus, at the nanometer scale (namely below 30 nm).

In reference to Figure 1, the second step 102 consists in measuring, using a microscopy tool the first and second distances OFFSET1, OFFSET2 between the targets 21,22 of the reference device 2 and the structure 1.

Advantageously, the microscopy tool can be a scanning electron microscope SEM. Such a microscope can achieve imaging resolutions better than 5 nm.

Advantageously, the scanning electron microscope SEM allows for non-destructive critical-dimension (or CD) measurements. In other words, the microscopy tool is a CD-SEM microscope. In the remainder of the description, a CD-SEM microscope will be considered as the microscopy tool. The first and second distances can then be measured with a better accuracy and repeatability.

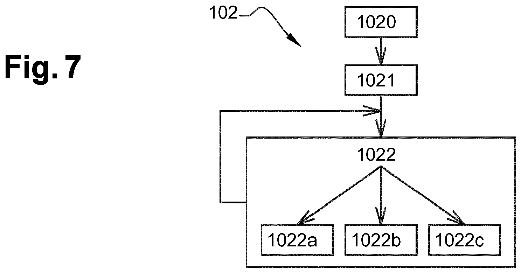

Figure 7 is a flowchart showing the main sub-steps of step 102. The microscopy tool considered is a CD-SEM microscope.

The first sub-step 1020 consists in configuring the CD-SEM microscope so to process the substrate 3. It includes the setup of a program called a recipe which is a series of files containing information on measurement conditions, namely where, how and what to measure. The recipe controls parameters such as auto focus, pattern recognition and measurement parameters.

Preferably the recipe is configured so that the CD-SEM microscope automatically moves to the first target 21 position, perform the measurement of the first distance OFFSET1, and then automatically moves to the second target 22 position and perform the measurement of the second distance OFFSET2.

In a sub-step 1021, the first and second images IMG1 and IMG2 are acquired using the CD-SEM microscope.

Precisely, the first image IMG1 which is acquired is of a first local aera including the first target 21 and the first edge 11 (precisely, at least a portion of the first edge 11 facing, or adjacent to, the first target 21). The second image IMG2 that is acquired is of a second local aera including the second target 22 and the second edge 12 (precisely, at least a portion of the second edge facing, or adjacent to, the second target 21).

As explained previously, the size of the first and second local aeras (thereby the size of the first and second image IMG1, IMG2) depends on how close the first target 21 is positioned with respect to the first edge and how close the second target 22 is positioned with respect to the second edge, respectively.

For example, when the distance OFFSET1 between the first target and the first edge and the distance OFFSET2 between the second target and the second edge are less than 5 µm, the field of view of the first image IMG1 can be a few microns square, for instance 5 µm × 5 µm, 3 µm × 3 µm or 1 µm × 1 µm, or less (and so is the size of the first and second local aeras). The first and second images IMG1 and IMG2 have then a resolution at the nanometer scale.

The image represented in Figure 4 is an example of a first image IMG1 acquired using a CD-SEM. The size of this image IMG1 is 1 µm × 1 µm and the resolution better than 30 nm. In this image IMG1, the entire target 21 is visible.

When a bridge-like structure 20 is used as the first target 21, as illustrated in Figure 5, the first image IMG1 can have a field-of view FOV large enough to capture the entire bridge-like structure 20.

Alternatively, the first image IMG1 can be reconstructed using two or more sub-images of smaller sizes (or smaller FOV) and higher resolution acquired sequentially. The first reconstructed image IMG1 then captures the entire bridge-like structure with a better resolution. Each of these sub-images captures in this case a different part of the bridge-like structure 20 and the first edge 11. For instance, the first image IMG1 can be reconstructed from a first sub-image that includes the first mark 20-1 and the first edge 11 and from a second sub-image that includes the second mark 20-2 and the first edge 11. The second image IMG2 can be obtained in the same way, by using two or more sub-images.

During a sub-step 1022, at least a pair of a first distance and a second distance {OFFSET1, OFFSET2} is measured on the first and second images IMG1 and IMG2, respectively.

The first and second distances of a pair of first and second distances {OFFSET1, OFFSET2} are measured using a mark of the first target and a mark of the second target that faces the mark of the first target, as described below.

In the case of a first target 21 made of a single mark 21-1, and a second target 22 made of another single mark 22-1 (as illustrated in figure 3), one pair of first and second distances {OFFSET1, OFFSET2} is measured: the first distance OFFSET1 of the pair is measured between the first edge 11 and the mark 21-1, and the second distance OFFSET2 of the pair is measured between the second edge 12 and the mark 22-1.

In the case of a first target 21 made of the bridge-like structure 20 (cf. Figure 5), and a second target 22 made of another bridge-like structure 20 (not represented), several pairs of first and second distances {OFFSET1, OFFSET2} are preferably measured.

For example, as illustrated in Figure 5, a first pair of first and second distances {OFFSET1, OFFSET2} can be measured at the bottom of the bridge-like structures (in this case, the first distance OFFSET1 is the distance OFFSET1-1 or the distance OFFSET1-2, and the second distance OFFSET2 is the corresponding distances between the second edge and the second target).

A second pair of first and second distances can be measured at the top of the bridge-like structures 20 (in this case, the first distance1 is measured between the portion of the first edge located under the plate 203 of the first target and one or the other end of this plate 203 and the second distance is measured between the portion of the second edge located under the plate 203 of the second target and one or the other end of this plate 203).

Besides, a pair of first and second distances can be measured on the structure 1 and a pair of first and second distances can be measured outside the structure.

By offering multiple marks and multiple locations along the first edge to obtain pairs of first and second distances, it is possible to consider (and compensate for) the irregularities (or variability) of the first and second edges 11,12 of the structure 1.

The measurement of the first distance OFFSET1 and second distance OFFSET2 can be performed in various ways (cf. Figure 7), each way being well-known by the skilled person in the art and, in some instances, already implemented in the CD-SEM microscope.

A first way 1022a is called "CD-SEM from extracted edges" and is explained in relation to figure 4 for the measurement of the first distance OFFSET1.

The "CD-SEM from extracted edges" method consists in analyzing line by line (see for instance line LP in Figure 4) a small aera of the first image IMG1.

The analysis leads to the identification (or extraction) of the first edge 11, the identification of a first end 21-2a of the mark 21-2 of the first target 21, and the identification of a second end 21-2b of the mark 21-2 of the first target 21. The first and second ends 21-2a and 21-2b corresponds to the edges of the mark 21-2 of the first target 21 that are parallel to the first edge 11. The first distance OFFSET1 is then derived from the distance OFFSET1a between the extracted first edge 11 and the first end 21-2a of the mark 21-2 of the first target 21, or from the distance OFFSET1b between the extracted first edge 11 and the second end 21-2b of the mark 21-2 of the first target 21.

A second way 1022b is called "CD-SEM from contours" and is explained using the same figure 4.

In this case, the whole first or second image IMG1, IMG2 is analyzed. The CD-SEM from contours consists in identifying, for instance using pattern recognition algorithms, the contours of the first edge 11 and the contours of the mark 21-2 of the first target 21. Then, the contours are represented using polygons, leading to a first polygon representing the first edge and a second polygon representing the mark 21-2 of the first target 21 (not represented). The fist offset OFFSET1 is eventually derived from the distance between the first and second polygons (not represented).

A third way 1022c is called "CD-SEM from positions".

The first distance OFFSET1 is derived from the distance between a first position and a second position. Using the example above, the first position is the position of the first edge 11 and the second position is the position of the mark 21-2 of the first target 21. The first position can be determined whether from the extracted first edge if the "CD-SEM from extracted edges" 1022a method is used, or from the geometric parameters (for instance from the barycenter) of the first polygon if the "CD-SEM from contours" is used 1022b. The second position is determined from the midpoint between the extracted ends 21-2a and 21-2b 1022a or from the barycenter of the second polygon 1022b.

The "CD-SEM from positions" method 1022c enables to improve the accuracy of the measurement of the distances OFFSET1, OFFSET2.

Advantageously, when the first and second targets are made of a bridge-like structure 20, the step 102 comprises a sub-step that is aimed at determining experimentally the predefined reference distance DREF. The value of the predefined reference distance DREF determined experimentally is closer to the actual physical value of the predefined reference distance compared to the theoretical value, determined by design.

This sub-step comprises then the determination of a barycenter of the first target and a barycenter of the second target.

The barycenter of the first target is deduced from several distances measured, in the first image IMG1, between the marks of the first target 21. For instance, the barycenter of the first target can be deduced from the distance measured between the first and second marks 20-1, 20-2, the distance measured between the third and the fourth mark 20-3, 20-4, and the distance measured between the first and fifth mark 20-1 and 20-5.

The barycenter of the second target is deduced similarly to the barycenter of the first target, from several distances measured in the second images IMG2, between the marks of the second target 22.

Then the experimentally determined predefined reference distance is deduced from the coordinates of the two barycenters (of the first and second targets).

The third step 103 follows the second step 102 and consists in determining the dimension DM1 of the structure 1 from the at least one pair of measured first and second distances {OFFSET1, OFFSET2} and from the predefined reference distance DREF of the reference device 2. Precisely, as illustrated in Figure 3, the sum of the first and second distances is subtracted from the predefined reference distance DREF and the result determines the dimension DM1.

In other words, during step 103, the predefined reference distance DREF is used together with the results of the measurements of the distances OFFSET1, OFFSET2 at each edge 11,12 of the structure 1, to determine the dimension DM1 of the structure 1.

One of the advantages of the method 100 is that the dimension DM1 of the structure 1 is determined with an accuracy that is uncorrelated to the value of the dimension DM1. This accuracy depends basically on the placement accuracy of the lithography apparatus that is used to form the first and second targets 21, 22 on the substrate 3. The accuracy depends, further, on the imaging capability of the microscopy tool used to acquire the first and second images IMG1, IMG2.

When a lithography tool such as an EBL apparatus is used to form the first and second targets, and a CD-SEM microscope is used to acquire the first and second images, the dimension of the structure can be in the millimeter range, typically larger than 500 µm or larger than 1 mm and be determined with an accuracy that is lower than 30 nm.

Moreover, since only two images are acquired and one measurement on each of these images are only needed, the method 100 is simpler than the current methods based on image stitching.

Additionnaly, when the bridge-like structure is used for each first and second targets 21,22, and several pairs of first distance and second distances are obtained in step 102, the dimension DM1 is determined for each of these pairs. The method 100 is thus more robust to irregularities present on the structure's edges.

Besides, when the predefined reference distance DREF is determined experimentally and this value is used instep 103, the dimension DM1 is determined more accurately. The metrology is thus improved.

Preferably, the method 100 comprises a step 104 that follows step 103. Step 104 consists in removing the first and second targets 21,22 from the substrate 3. Importantly, the step 104 does not alter the structure 1 nor the substrate surface 31. Many processes enabling the removal of a resist layer can be applied at step 105: reactive ion etching, plasma ashing, etc. For instance, a reactive ion etching (or RIE) process is performed at step 104.

Step 104 allows the method 100 to be fully non-invasive and non-destructive.

The method 100 is therefore a fast, non-destructive method that meets the constraints of measuring millimetric dimensions with an accuracy that can be less than 30 nm.

The method 100 can advantageously be used for the measurement of a plurality of dimensions DM1, DM2 within the structure 1, and/or for the measurement of a plurality of dimensions of a plurality of structures formed on a single substrate. In addition, the method 100 can be automated at the scale of a wafer or a wafer lot.

## Claims

1. Method (100) for determining a dimension (DM1) between two opposite edges (11,12) of a structure (1) formed on a substrate (3) comprising the steps of:
- Forming (101) on the substrate (3), using a lithographic apparatus, a reference device (2) comprising two targets (21,22) facing each other and separated by a predefined reference distance (DREF),
∘ Wherein the first target (21) is positioned close to a first edge (11) of the two opposite edges (11,12),
∘ wherein the second target (22) is positioned close to a second edge (12) of the two opposite edges (11,12), said first and second targets (11,12) being separated by said predefined reference distance (DREF),
- Performing (102), using a microscopy tool, two dimensional measurements between the structure and the formed reference device, by:
∘ Acquiring (1021) a first image (IMG1) of a first local aera including the first target (21) and the first edge (11), and a second image (IMG2) of a second local aera including the second target (22) and the second edge (12),
∘ Measuring (1022) in the first image (IMG1) a first distance (OFFSET1) between the first target (21) and the first edge (11), and, in the second image (IMG2), a second distance (OFFSET2) between the second target (22) and the second edge (12),
- Computing (103) the measured first and second distances (OFFSET1, OFFSET2) and the predefined reference distance (DREF) to determine the dimension (DM1) between the opposite edges (11,12).

2. Method (100) according to the preceding claim, wherein the first target (21) is positioned with respect to the first edge (11) of the structure (1) so that the first distance (OFFSET1) is less than or equal to 50 µm, more preferably less than or equal to 10 µm, and for instance less than or equal to 5 µm, and the second the second target (22) is positioned with respect to the second edge (12) of the structure (1) so that the second distance (OFFSET2) is less than or equal to 50 µm, more preferably less than or equal to 10 µm, and for instance less than or equal to 5 µm.

3. Method (100) according to any of the preceding claims, wherein the first target (21) overlaps the first edge (11) of the structure (1), or is positioned, with respect to the first edge (11) of the structure, outside (31) the structure (1) or on (10) the structure (1), and the first target (21) has at least an end (21-1a, 21-1b) facing a portion of the first edge (11) of the structure (1), the distance between the end (21-1a, 21-1b) of the first target (21) and the portion of the first edge (11) being equal to the first distance (OFFSET1).

4. Method (100) according to any of the preceding claims, wherein the second target (22) overlaps the second edge (12) of the structure (1) or is positioned, with respect to the second edge (12) of the structure, outside (31) the structure (1) or on (10) the structure (1), and the second target (22) has at least an end (22-1a, 22-1b) facing a portion of the second edge (12) of the structure (1), the distance between the end (22-1a, 22-1b) of the second target (22) and the portion of the second edge (12) being equal to the second distance (OFFSET2).

5. Method (100) according to any of the preceding claims, wherein the lithographic apparatus can form patterns with a lateral resolution of at least 10 nm and placement accuracy of at least 1 nm.

6. Method (100) according to claim 5, wherein the lithographic apparatus is an electron beam apparatus.

7. Method (100) according to any of the preceding claims, wherein the first and second images (IMG1, IMG2) obtained by the microscopy tool have a resolution in the range of nanometer scale.

8. Method (100) according to any of the preceding claims wherein the microscopy tool is a critical-dimension scanning electron microscope also called CD-SEM.

9. Method (100) according to any of the preceding claims wherein the computing step (103) is followed by an additional step of selective removing (105) of the first and second targets (21,22) from the substrate.

10. Method (100) according to any of the preceding claims wherein the first target (21) and the second target (22) are each made of one mark or of a plurality of marks, wherein each mark of the plurality of marks is connected to at least another mark of the plurality of marks.

11. Method (100) according to claim 10, wherein the first target (21) and the second target (22) are each made of five marks having rectangular shapes and arranged such to form a bridge-like structure (20), the bridge-like structure (20) including two pillars (201,202), and a plate (203) extending over the two pillars (201,202), perpendicularly to the two pillars (201,202) and connected to the two pillars.

12. Method according to claim 11, wherein the plate (203) of the bridge-like structure (20) of the first target (21) overlaps the first edge (11) of the structure and the pillars (201, 202) of the bridge-like structure (20) of the first target (11) are positioned on each side (10, 31) of the first edge of the structure (1), and the plate (203) of the bridge-like structure (20) of the second target (22) overlaps the second edge (12) of the structure (1) and the pillars (201, 202) of the bridge-like structure (20) of the second target (22) are positioned on each side (10, 31) of the second edge (12) of the structure (1).
